Europäisches Patentamt

(19) European Patent Office

Office européen des brevets

(11) Veröffentlichungsnummer: **0 028 585**
. B1

(12) **EUROPÄISCHE PATENTSCHRIFT**

(45) Veröffentlichungstag der Patentschrift:
27.02.85

(51) Int. Cl.⁴: **H 01 J 37/00,** H 01 J 3/00,
H 01 L 21/26

(21) Anmeldenummer: 80810330.3

(22) Anmeldetag: 31.10.80

(54) Verfahren und Vorrichtung zur Korpuskularbestrahlung.

(30) Priorität: 01.11.79 DD 216600
01.10.80 DD 224257

(43) Veröffentlichungstag der Anmeldung:
13.05.81 Patentblatt 81/19

(45) Bekanntmachung des Hinweises auf die Patenterteilung:
27.02.85 Patentblatt 85/9

(84) Benannte Vertragsstaaten:
DE FR GB

(56) Entgegenhaltungen:
CH - A - 241 526
CH - A - 247 329
DE - A - 2 123 786
DE - A - 2 623 337
DE - B - 1 110 342
FR - A - 861 705
FR - A - 874 627
FR - A - 1 587 400

(73) Patentinhaber: Jenoptik Jena G.m.b.H.,
Carl-Zeiss-Strasse 1, DDR-6900 Jena (DD)

(84) Benannte Vertragsstaaten: DE

(73) Patentinhaber: VEB Carl Zeiss Jena,
Carl-Zeiss-Strasse 1, DDR-6900 Jena (DD)

(84) Benannte Vertragsstaaten: FR GB

(72) Erfinder: Hahn, Eberhard, Dr., Pestalozzistrasse 9,
DDR-6900 Jena (DD)

(74) Vertreter: Schweizer, Hans et al, Bovard AG
Patentanwälte VSP Optingenstrasse 16,
CH-3000 Bern 25 (CH)

## Beschreibung

Die Erfindung bezieht sich auf ein Verfahren und eine Vorrichtung zur Korpuskularbestrahlung, insbesondere Elektronenbestrahlung eines Targets zur Erzeugung eines Belichtungsmusters, bei dem ein Korpuskularstrahlenbündel im Querschnitt begrenzt, in seiner Intensität strukturiert und auf das Target übertragen wird und bei dem elektromagnetische Felder zum Fokussieren und Ablenken des Korpuskularstrahlenbündels erzeugt werden.

Bekanntlich wird bei der Elektronenstrahlbearbeitung ein Target mit einer Elektronenstrahlsonde zeilenweise abgetastet. Je nachdem, ob sich dabei der Elektronenstrahl auf einem zu bestrahlenden oder nicht zu bestrahlenden Gebiet befindet, wird er durch Auslenkung hell oder dunkel getastet. Der Nachteil dieser Anordnung besteht darin, dass die Zeit, die der Elektronenstrahl zur Dunkeltastung über ein Target benötigt, ein Vielfaches der Zeit zur Helltastung betragen kann und den Abtastvorgang erheblich belastet. Dieser Nachteil wird behoben, wenn ein zu bestrahlendes Muster in Form einer Schablone benutzt wird, die gleichmässig mit Elektronen bestrahlt und auf ein Target abgebildet wird. Diesem bekannten Verfahren haftet jedoch der Nachteil an, dass für jedes Muster eine Schablone hergestellt und in den Strahlengang einjustiert werden muss und dass es dadurch bezüglich der Vielfalt der zu verwendenden Muster wenig flexibel ist.

Bekannt ist auch ein Verfahren der Elektronenbestrahlung, bei dem jedes zu bestrahlende Muster in eine Vielzahl von vorzugsweise rechteckigen Flächenelementen unterschiedlicher Form und Grösse zerlegt und die Lage, Form und Grösse der Flächenelemente einem Elektronenstrahlbündel durch Ablenkfelder aufgeprägt wird. Auf Grund der endlichen Geschwindigkeiten bei der Auswahl und Übertragung der Daten, der Digital-Analog-Wandlung und der Strahlablenkung entstehen jedoch erhebliche Totzeiten bei der Belichtung des Targets, die die Produktivität der Bestrahlung eines Targets erheblich beschränken.

Weiterhin ist ein Verfahren der Elektronenbestrahlung bekannt geworden, bei dem ein Sortiment von nach Form und Grösse einstellbaren Strahlquerschnitten bereitgestellt wird, von denen jeweils einer zur Bestrahlung eines Targets benutzt wird. Damit wird zwar für schräge und kreisförmige Figuren (Strahlquerschnitte) eine höhere Arbeitsgeschwindigkeit erzielt. Jedoch sind infolge der Zugriffszeiten zu den einzelnen Figuren die Totzeiten im Strahlungsprozess unverändert vorhanden.

Es sind auch bereits Elektronenmikroskope mit magnetischen Umlenkprismen und Elektronenspiegeln bekannt. Die Elektronenspiegel sind in ihrer Gesamtheit mit einem elektrischen Potential versehen.

Schliesslich ist ein Elektronenmikroskop bekannt, bei dem mit Hilfe von Quadrupollinsen ein Elektronenstrahlbündel in Form einer Linie auf ein Objekt und auf einem Bildträger fokussiert wird. Durch die Strukturierung des Objektes wird auch der Elektronenstrahl und damit die Strichsonde strukturiert. Das Objekt kann als Raster aufgefasst werden, dessen Elemente durchlässig und nichtdurchlässig sind und das demzufolge wie eine Schablone wirkt. Die Struktur der Strichsonde ist nicht frei programmierbar; deshalb ist eine hohe Arbeitsproduktivität nicht erreichbar. Ausserdem ist der Zugriff zu einer in einem Sortiment enthaltenen Struktur zeitaufwendig und an die Verwendung von DA-Wandlern gebunden.

In der FR-A Nr. 847627 ist eine elektronische Einrichtung mit einer als Spiegel für ein Elektronenbündel oder ein Bündel mit geladenen Teilchen dienenden Elektrodenanordnung beschrieben. Die Elektrodenanordnung besteht aus einer Anzahl von Elektroden in der Form von konzentrischen Metallstreifen oder Drähten. Die einzelnen Elektroden sind mit je einem von einer Anzahl Abgriffen eines Spannungsteilers so verbunden, dass an die innerste Elektrode die grösste und an die äusserste Elektrode die kleinste Spannung anliegt. Durch Ändern der an den Spannungsteiler angelegten Spannung kann die wirksame Spiegelfläche konvex oder konkav gemacht, d.h. die Brennweite des durch die Elektrodenanordnung gebildeten Spiegels gesteuert werden. Es ist somit möglich, das genannte Bündel zu modulieren. Durch eine solche Modulation kann aber nur die Grösse des Querschnittes des Bündels, betrachtet an einer bestimmten Stelle, verändert werden, wobei naturgemäss auch die Intensität pro Flächeneinheit gleichmässig über den ganzen Querschnitt des Bündels ändert.

Die in der DE-AI Nr. 2123786 beschriebene Vorrichtung zum Trennen geladener Teilchen in Abhängigkeit von ihrer jeweiligen Energie umfasst eine Ladungsträgerquelle. Die aus dieser austretenden geladenen Teilchen gelangen durch eine Ablenkspule zu einer Schlitzblende.

Die durch die Schlitzblende hindurchtretenden Teilchen gelangen in ein magnetisches Feld, von welchem sie um etwa 90° umgelenkt werden und in eine zylindrische Elektrode eintreten. Die Teilchen werden durch ein zwischen der genannten Elektrode und einer weiteren zylindrischen Elektrode gebildetes elektrisches Verzögerungsfeld verzögert. Die Teilchen wandern mit relativ geringer Geschwindigkeit durch die weitere zylindrische Elektrode hindurch und gelangen zu einer am anderen Ende der weiteren zylindrischen Elektrode angeordneten Spiegelelektrode. Diese erzeugt ein die Teilchen reflektierendes elektrisches Feld, so dass die Teilchen durch die beiden genannten zylindrischen Elektroden zurück zum genannten magnetischen Feld wandern. Dabei werden die Teilchen durch die erstgenannte zylindrische Elektrode wieder beschleunigt. Vom magnetischen Feld werden die beschleunigten Teilchen auf einen Detektor umgelenkt. Das vom Detektor erzeugte Signal wird einem Synchroskop zugeführt, das eine Energieverteilungskurve der getrennten Teilchen aufzeichnet. Von der genannten Spiegelelektrode wird das auf sie auftreffende Teilchenbündel lediglich reflektiert und dessen Querschnitt nicht verändert.

Aufgabe der Erfindung ist es, ein Verfahren und eine Vorrichtung zur Korpuskularbestrahlung, insbesondere zur Elektronenstrahlbearbeitung, zu schaffen, die praktisch beliebige Muster ohne jede Verzögerungszeit dem gesamten Querschnitt eines Strahlenbündels aufzuprägen gestatten. Die in der Ebene des Targets erscheinende Strahlsonde soll freiprogrammierbar sein.

Das erfindungsgemässe Verfahren ist durch die im kennzeichnenden Teil des Anspruches 1 angeführten Merkmale gekennzeichnet.

Dadurch ist es möglich, dem Querschnitt eines Korpuskularstrahlenbündels trägheitslos eine beliebige, vorprogrammierbare Intensitätsverteilung zu geben und extrem niedrige Bearbeitungszeiten bei der Korpuskularbestrahlung von Objekten ohne Intensitätsverluste im strukturierten Querschnitt zu erreichen. Die Erfindung kann zur Elektronenstrahlbearbeitung von Resists mit normaler Empfindlichkeit vorteilhaft hochproduktiv verwendet werden. Für die Wirkungsweise der Erfindung ist die Form des Strahlbündelquerschnitts und die Art des erzeugten Feldes (elektrisch oder magnetisch) ohne Bedeutung. Der Strahlenbündelquerschnitt hat vorzugsweise eine rechteckige oder linienartige Form.

Die erfindungsgemässe Vorrichtung zum Durchführen des Verfahrens ist im Anspruch 2 definiert.

Die Vorrichtung zeichnet sich dadurch aus, dass die Oberfläche des Elektronenspiegels matrixartig ausgebildet und die einzelnen Matrixelemente voneinander elektrisch isoliert und mit einer Spannungsquelle über elektronische Schalter verbunden sind, die von einem Speichersystem gesteuert werden. Die Grösse der Oberfläche des Elektronenspiegels kann ein Mehrfaches des Strahlenbündelquerschnittes betragen. Dadurch ist es möglich, einen Teil der Elektroden zum Belichten des Targets zu benutzen und einen anderen Teil in der Zwischenzeit zu laden. Je nach dem Potential der Elektroden (z.B. 0 oder 10 V gegenüber Kathodenpotential) werden die Elektronen reflektiert oder absorbiert und wird damit dem Querschnitt des Elektronenstrahlbündels eine entsprechende Struktur aufgeprägt. Zur Vermeidung von Streustrahlungseffekten ist zumindest in der Nähe der bildseitigen Brennebene des Beschleunigungsfeldes des Elektronenspiegels eine Blende angeordnet.

Eine andere, Streustrahlung und damit Intensitätsverluste vermeidende Vorrichtung zur Durchführung des Verfahrens bildet eine Strahlquelle durch eine Quadrupoloptik astigmatisch in eine erste und zweite reelle Brennlinie stigmatisch auf ein Target ab. Die andere Vorrichtung ist dadurch gekennzeichnet, dass die zweite Brennlinie auf die Öffnung einer Spaltblende eingestellt ist und dass parallel und in unmittelbarer Nähe zur ersten Brennlinie mindestens eine Elektrodenzeile angeordnet ist, deren Elektroden voneinander elektrisch isoliert und mit einer Spannungsquelle über elektronische Schalter verbunden sind, die von einem Speichersystem gesteuert werden. Damit wird gleichzeitig ein Übersprechen zwischen benachbarten Elektroden vermieden. Vorteilhaft ist es, die Elektrodenzeile entlang der Kante einer Halbleiterscheibe anzuordnen, wobei die einzelnen Elektroden die Kante überragen. Auf der Halbleiterscheibe können dann mikroelektronische Bauelemente bzw. Schaltkreise durch mikrolithografische Verfahrenstechniken installiert sein. Solche Bauelemente sind insbesondere elektronische Schalter und Multiplexer, die eine Reduzierung der Anzahl der Steuerleitungen zwischen den Elektroden und dem Datenausgang eines dynamischen Speichersystems im Verhältnis seiner Taktfrequenz zur Belichtungsfrequenz des Targets ermöglichen. In unmittelbarer Nähe der ersten Brennlinie kann der ersten Elektrodenzeile gegenüberliegend eine zweite Elektrodenzeile angeordnet sein, die geladen wird, wenn die erste Elektrodenzeile der Belichtung dient. Vorteilhaft ist es ferner, wenn die Elektroden im Verhältnis zu ihren Abständen dünn ausgebildet und damit der mikrolithografischen Herstellungstechnik besser zugänglich sind. Schliesslich ergibt sich eine vorteilhafte Bestrahlungsanordnung, wenn die Linsenanordnung ebenfalls eine Quadrupoloptik ist.

Nachfolgend wird die Erfindung anhand der schematischen Zeichnung näher erläutert.

Es zeigen:

Fig. 1 eine erfindungsgemässe Vorrichtung,

Fig. 2 das Elektronikschema zu Fig. 1,

Fig. 3 eine zweite erfindungsgemässe Vorrichtung, und

Fig. 4 eine Demonstration des Feldstärkeverlaufs an der Elektrodenzeile.

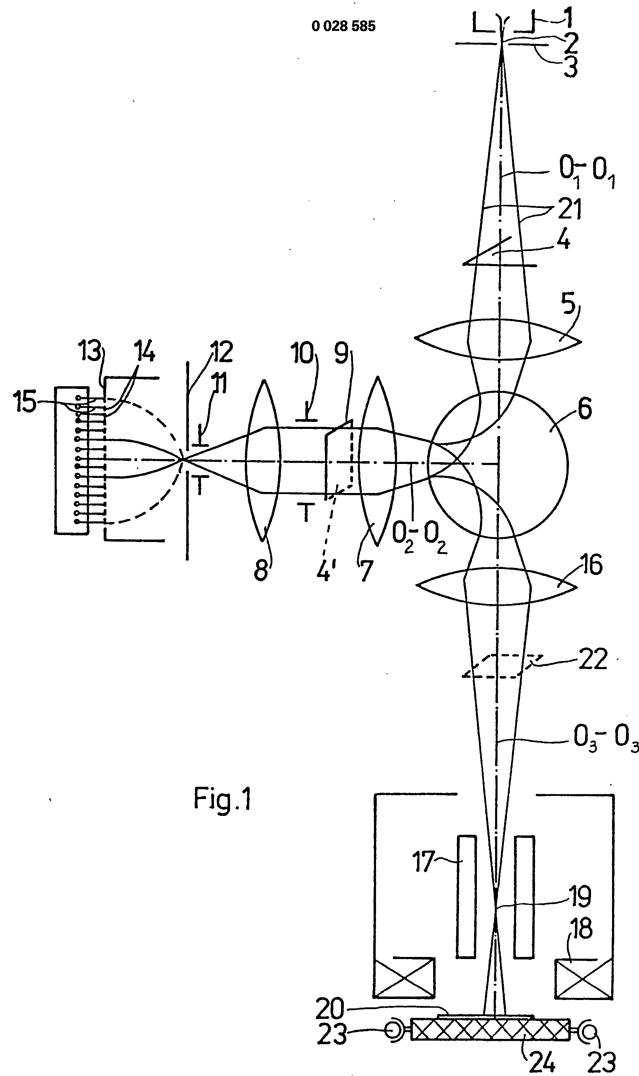

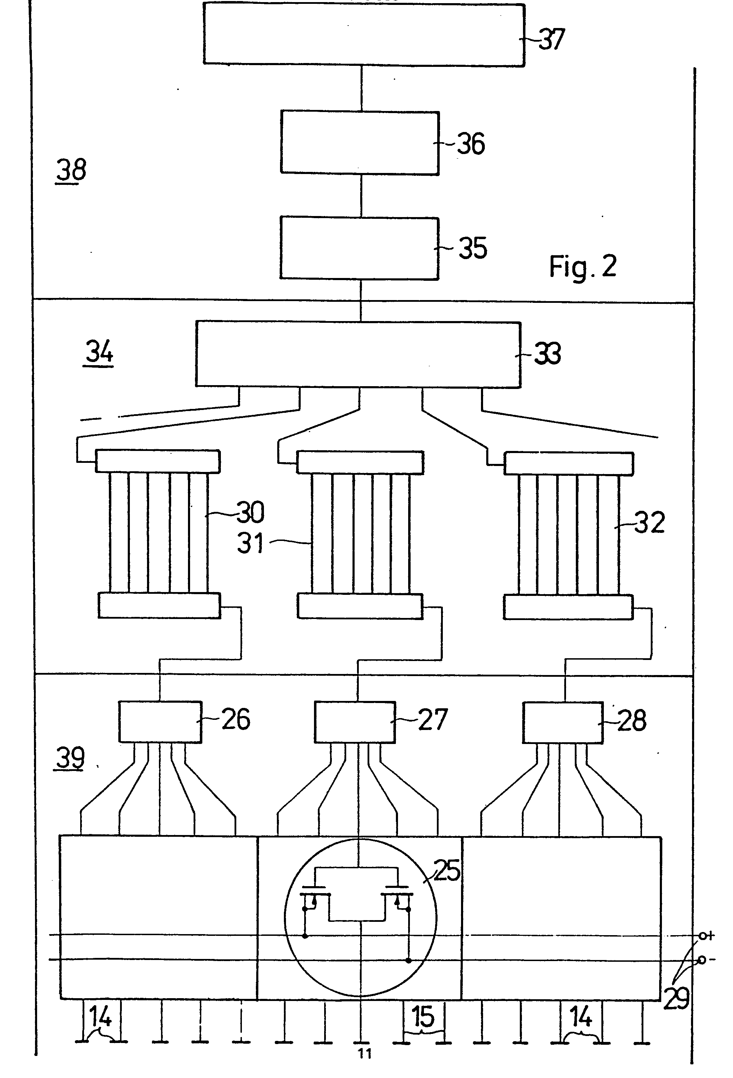

In Fig. 1 ist ein Strahler 1 mit einem Cross-over 2 und einer Blende 3 vorgesehen, denen eine Winkelblende 4, ein Kondensor 5 und ein magnetisches Umlenkprisma 6 nachgeordnet sind. Das Umlenkprisma 6 kann aus zwei in achsensenkrechter Richtung sich gegenüberstehenden Polschuhen mit kreisförmigem Querschnitt bestehen, die durch einen einem optischen System 7, 8 gegenüberliegenden Eisenkreis verbunden sind, der Erregerwicklungen trägt (nicht dargestellt). Das optische System mit den Kondensorlinsen 7, 8 hat eine optische Achse $O_2$-$O_2$, die mit der optischen Achse $O_1$-$O_1$ des Kondensors 5 nicht zusammenfällt und im dargestellten Ausführungsbeispiel einen Winkel von 90° einschliesst. Zwischen den Kondensorlinsen 7 und 8 sind eine Winkelblende 9 und ein Ablenksystem 10 vorgesehen. Dem optischen System 7, 8 sind, ebenfalls zur optischen Achse $O_2$-$O_2$ ausgerichtet, ein weiteres Ablenksystem 11, eine Streustrahlblende 12 und ein Elektronenspiegel 13 nachgeordnet, der an seiner reflektierenden Oberfläche eine Matrix von Elektroden 14 aufweist, deren Ausgänge 15 über elektronische Schalter zu Multiplexern führen (Fig. 2). Die Streustrahlblende 12 befindet sich in der Ebene einer Zwischenpupille. Entlang einer dritten optischen Achse $O_3$-$O_3$ sind dem Umlenkprisma 6 ein weiterer Kondensor 16, ein Ablenksystem 17, ein Ablenkobjektiv 18 mit einer Zwischenbildebene 19 und ein mit Hilfe von Führungen 23 und eines Schlittens 24 rechtwinklig zur Zeichenebene verschiebbares Target 20 nachgeordnet.

Ein vom Cross-over 2 ausgehendes Strahlenbündel 21 erfährt durch die Winkelblende 4 eine erste formgebende Beschneidung und wird durch den Kondensor 5 asymptotisch auf die Mitte des Umlenkprismas 6 fokussiert, das das Strahlenbündel 21 um 90° in die Richtung der optischen Achse $O_2$-$O_2$ ablenkt. Die Winkelblende 4 erscheint als Bild 4' in der Ebene der Winkelblende 9 und nimmt zu dieser eine im Sinne der Strahlformung komplementäre Lage ein. Die Winkelblenden 4 und 9 sind so eingestellt, dass der durch sie in der Ebene der Winkelblende 9 geformte Querschnitt des Strahlenbündels 21 vorzugsweise quadratisch ist. Der Kondensor 5 und die Kondensorlinse 7 bilden ein teleskopisches System zur Abbildung der Winkelblenden aufeinander. Die Kondensorlinse 8 bildet den durch die Winkelblenden 4, 9 geformten Querschnitt auf die Oberfläche des Elektronenspiegels 13 ab. An die einzelnen Elektroden 14 des Elektronenspiegels 13 sind entsprechend einem vorgegebenen Programm Spannungen von 0 bis 10 V angelegt, so dass die Elektronen des Strahlenbündels 21 entsprechend abgebremst, reflektiert oder absorbiert werden. Die Anordnung ist so getroffen, dass in der Öffnung der Streustrahlblende 12 ein Zwischenbild des Cross-over 2 entsteht und dass die Strahlen 21 auf die Spiegeloberfläche senkrecht einfallen und nach Reflexion an der Spiegeloberfläche in sich zurückkehren. Da die Spiegeloberfläche allein schon durch die Elektrodenmatrix strukturiert ist, ist die Reflexion am Elektronenspiegel 13 nicht ideal, es findet eine erhebliche Strahlenstreuung statt, deren Einfluss durch die Streustrahlblende 12 reduziert bzw. unschädlich gemacht wird. Das am Elektronenspiegel 13 reflektierte Strahlenbündel 21 entwirft durch die Kondensorlinse 8 ein Zwischenbild des geformten Bündelquerschnittes in der Ebene der Winkelblende 9 und nach Umlenkung im Umlenkprisma 6 durch den Kondensor 16 ein gleiches Zwischenbild 22 in einer Ebene vor dem Ablenksystem 17 des Ablenkobjektivs 18. Durch den Kondensor 16 wird der Cross-over 2 nochmals, und zwar auf die Eintrittspupille 19 des Ablenkobjektivs 18, abgebildet, das seinerseits auf dem Target 20 mit hoher Stromdichte und frei von Aberrationen das Bild des geformten und durch die unterschiedlichen, an den Elektroden 14 des Elektronenspiegels 13 anliegenden Spannungen intensitätsmässig strukturierten Bündelquerschnitts erzeugt. Das Ablenksystem 17 verschiebt das Bild des Bündelquerschnitts auf dem Target 20, so dass auch andere Targetbereiche bestrahlt werden können.

Die Erfindung ist nicht an die in Fig. 1 dargestellte 90°-Umlenkung des Strahlenbündels 21 im Umlenkprisma 6 gebunden. Ebenso kann der geformte Bündelquerschnitt von der quadratischen Form abweichen und eine rechteckige oder linienartige Form annehmen. Hierzu muss in den Polschuhspalt des Umlenkprismas 6 ein elektrischer Plattenkondensator eingefügt werden, dessen elektrische Feldstärke parallel zur Magnetfeldstärke gerichtet ist und bei dem beide Feldstärken einstellbar sind. Zur Reproduktion eines definierten und festen Musters kann die Oberfläche des Elektronenspiegels 13 nach Art einer Schablone topografisch präpariert werden. Es ist auch möglich, den Elektronenspiegel 13 in mindestens zwei Unterfelder aufzuteilen, von denen eines jeweils das Strahlenbündel 21 beeinflusst, das andere sich im Zustand des Umladens der Elektroden befindet und in seinem Wirksamwerden auf das Strahlenbündel vorbereitet wird. Das Ablenksystem 17 lässt diese Unterfelder in einer vorbestimmten Reihenfolge wirksam werden. Der Elektronenspiegel 13 kann auch gekrümmt sein. Jedoch erleichtert seine ebene Form die lithografische Herstellung.

Die Kondensorlinsen 7 und 8 können als Quadrupolsysteme ausgebildet sein, die Ablenksysteme und Zylinderlinsen enthalten.

In Fig. 2 sind wieder die Elektroden 14 mit den Zuleitungen 15 erkennbar, von denen jede über einen elektronischen Schalter 25 (CMOS-Transistor) der exemplarisch dargestellten Form mit einem Multiplexer 26 bzw. 27 bzw. 28 verbunden ist und das Binärpotential einer Spannungsquelle 29 steuert. Die Multiplexer 26, 27, 28 sind je mit einem Schieberegister 30 bzw. 31 bzw. 32 verbunden, das mit einer Steuereinrichtung 33 zum Steuern der Schieberegister 30, 31, 32 zu dynamischen Speicherblöcken 34 gehört. An die Steuereinrichtung 33 sind nacheinander ein Zwischenspeicher 35, ein Rechner 36 und eine Dateneingabe 37 angeschlossen, die der Datenaufbereitung dienen und in einer entsprechenden Einheit 38 zusammengefasst sind. Die Elektroden 14, elektronischen Schalter 25 und Multiplexer 26, 27, 28 können auf einer gemeinsamen Platte 39 angeordnet sein, die mit dem Elektronenspiegel (Fig. 1) eine Baueinheit bildet.

Die Dateneingabe 37 dient zur Aufnahme der das Belichtungsmuster beschreibenden Daten. Der Rechner 36 bereitet die Daten in der entsprechenden Binärform auf und setzt sie auf dem Zwischenspeicher 35 ab. Die Steuereinrichtung 33 vermittelt die Daten an die in den dynamischen Speicherblöcken 34 parallel angeordneten Schieberegister 30, 31, 32, von denen jedes die gleiche Anzahl k Speicherzellen aufweist. In jedem dynamischen Speicherblock sind i parallele Schieberegister mit einem Ein- und Ausgaberegister zu je i Speicherzellen angeordnet. Die Bitfolge gelangt mit hoher Frequenz i·f in das Eingaberegister, erfährt dort eine Umsetzung in die Parallelregister, durchläuft diese mit i-mal niedrigerer Taktfrequenz f, wird durch nochmalige Umsetzung in das Ausgaberegister übernommen und mit hoher Taktfrequenz an den jeweiligen Multiplexer 26 bzw. 27 bzw. 28 ausgegeben. Dort werden sie auf die i Schalterkanäle sukzessive verteilt und steuern das Binärpotential von i Elektroden einer Elektrodengruppe des Elektronenspiegels (Fig. 1). Der Ausleseprozess kann sich k-mal wiederholen, bis die in den Schieberegistern 30, 31, 32 enthaltenen Informationen ausgeschöpft sind. Mit m dynamischen Speicherblöcken können m·i Elektroden mit der Taktfrequenz f geladen werden. Die m Speicherblöcke haben eine Speicherkapazität von m·i·k bit, die zur Beschreibung eines Musters auf einem Target ausreicht. Zur Beschreibung eines Targets sind n Muster nötig. Es sind daher n·m Speicherblöcke vorzusehen, die einzeln über einen nicht dargestellten Steuerteil wahlweise an die Multiplexer geschaltet werden.

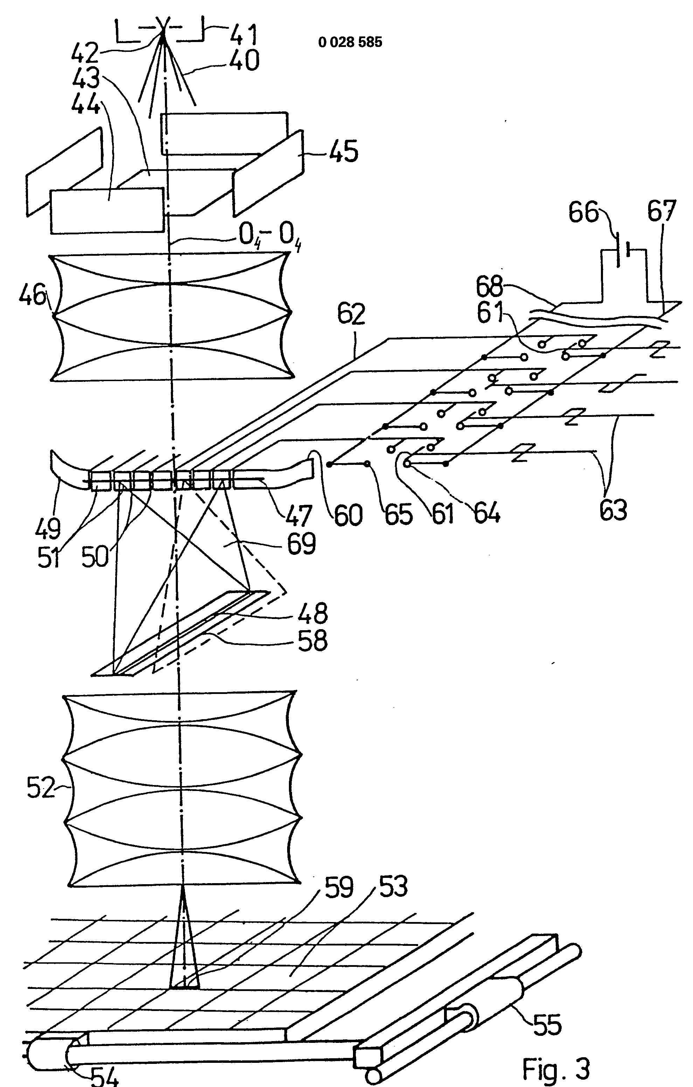

In Fig. 3 folgt einem Strahler 41 mit einem Cross-over 42 eine erste Strahlbegrenzungsblende (Leuchtfeldblende) 43 und eine Ablenkvorrichtung 44, 45 für ein Elektronenstrahlbündel 40 in zwei zueinander und zu einer optischen Achse $O_4$-$O_4$ rechtwinkligen Richtungen. Eine erste Quadrupoloptik 46 formt das vom Cross-over 42 ausgehende Strahlenbündel 40 astigmatisch zu zwei reellen, zueinander rechtwinkligen Brennlinien 47, 48. Eine Elektrodenleiste 49 ist der ersten Brennlinie 47 benachbart liegend und parallel zu ihr angeordnet. Die einzelnen Elektroden 50 sind schmale Stege, die durch breite isolierende Materialbereiche 51 voneinander getrennt sind und aus dem isolierenden Material herausragen. Parallel zur zweiten Brennlinie 48 ist eine Spaltblende (Selektorblende) 58 angeordnet. Eine zweite Quadrupoloptik 52 ist mit der ersten Quadrupoloptik 46 koaxial zur optischen Achse $O_4$-$O_4$ angeordnet und bildet die erste Brennlinie als Strichsonde 59 auf ein Target 53 stigmatisch ab. Das Target 53 ist mit Hilfe eines Kreuzschlittensystems 54, 55 in zwei zueinander senkrechten Richtungen 56, 57 verschiebbar angeordnet. Die Elektrodenleiste 49 befindet sich an der Schmalseite einer Halbleiterscheibe 60, auf der auch für jede Elektrode 50 ein elektronischer Schalter 61 sowie die entsprechende Verbindungsleitung 62 von der Elektrode zum elektronischen Schalter angeordnet sind. Ausserdem führt zum elektronischen Schalter 61 von einer nicht dargestellten Steuerelektronik (Fig. 2) eine Signalleitung 63. Zwei weitere Pole 64, 65 jedes elektronischen Schalters 61 sind mit das Binärpotential (beispielsweise 0 und 10 V gegenüber Masse) tragenden Leitern 67, 68 einer Spannungsquelle 66 verbunden. Je nach dem anliegenden Steuersignal wird das eine oder das andere Potential auf die mit dem Schalterausgang verbundene Elektrode 50 geschaltet.

Das vom Cross-over 42 ausgehende Strahlenbündel 40 leuchtet die Strahlbegrenzungsblende 43 nahezu gleichmässig aus und wird auf Grund der astigmatischen Abbildung durch die erste Quadrupoloptik 46 zu einem Strahlenkomplex 69 geformt, der durch die Brennlinien 47, 48 aufgespannt ist. Die Länge der beiden Brennlinien 47, 48 ist durch das astigmatische Abbild der Strahlbegrenzungsblende 43, ihre Breite durch das astigmatische Abbild des Cross-over 42 bestimmt. Die Brennlinien 47, 48 stehen senkrecht zur optischen Achse $O_4$-$O_4$, ihre Meridionalebenen sind optisch rechtwinklig zueinander gerichtet. Mit Hilfe der Ablenkvorrichtung 44 wird die Distanz der Brennlinie 47 zu einer Mittellinie der Elektrodenleiste 49 eingestellt. Die Ablenkvorrichtung 45 dient zur Verschiebung der Brennlinie 48 in Querrichtung und damit zur Justierung auf die Mitte der Spaltblende 58. Die zur optischen Achse $O_4$-$O_4$ rechtwinklige Ebene der Brennlinie 47 ist stigmatisch konjugiert zur Ebene des Targets 53, und es entsteht bei Einstellung der Brennlinie 47 auf freien Durchgang des Strahlenbündels 40 (grosse Distanz zur Elektrodenleiste 49) ein Abbild der Brennlinie 47 in der Targetebene, eine Strichsonde. Wird die Brennlinie 47 durch die Ablenkvorrichtung 44 in die Nähe der Elektrodenleiste 49 gebracht und gerät damit diese Brennlinie 47 bzw. das Elektronenstrahlbündel 40 unter den Einfluss der an den einzelnen Elektroden 50 unterschiedlich anliegenden Binärpotentiale, so wird die Intensität entlang der Brennlinie 47 unterschiedlich sein. Haben nämlich zwei benachbarte Elektroden der Elektrodenleiste 49, die ein Intervall auf der Brennlinie 47 definieren, ein unterschiedliches Potential, so wird zwischen ihnen eine elektrische Feldstärke erzeugt, die den durch das Intervall als Vertex und durch die Brennlinie 48 als Basis definierten Teilstrahlkomplex in senkrechter Richtung zur Basis auf den Rand der Spaltbende 58 ablenkt, was in Fig. 3 gestrichelt dargestellt ist. Das dem Intervall der Brennlinie 47 konjugierte Bildintervall der Strichsonde 59 ist dunkelgesteuert. Die auf der Strichsonde 59 in der Targetebene erzeugte binäre Strahlungsstruktur in Gestalt einer definierten Kette von hellen und dunklen Bildintervallen reproduziert auf dem Target 53 (auf dem bestrahlten Resist) eine entsprechende (latente) Bestrahlungsstruktur während der auf die Resistempfindlichkeit und die Sondenstromdichte abgestimmten Bestrahlungszeit. Nimmt die Strichsonde 59 nach der Bestrahlung eines Targetabschnittes durch Verschiebung des Targets 53 mit Hilfe des Kreuzschlittensystems 54, 55 gegenüber dem Target eine neue Position ein, so werden mit Hilfe der Steuerelektronik (Fig. 2) die Binärpotentiale der einzelnen Elektroden 50 und damit die Strahlungsstruktur in der Strichsonde 59 verändert. Totzeiten werden vermieden, wenn der Ladeprozess für die Elektroden 50 wesentlich kürzer ist als die Bestrahlungsdauer. Dazu werden die Signalleitungen 63 von der nicht dargestellten Steuerelektronik über ein nicht dargestelltes bitparallel und wortseriell organisiertes Speichersystem (Möschwitzer/Jorke, ,,Mikroelektronische Schaltkreise'', VEB Verlag Technik, Berlin 1979, Seiten 172 bis 175) und über Multiplexer (Fig. 2) zu den elektronischen Schaltern 61 geführt. Die Erzeugung der beiden Brennlinien 47, 48 erfolgt durch die Quadrupoloptik 46, wobei die an der Hell-Dunkelsteuerung gemessene Ablenkempfindlichkeit des von einem Intervall der Brennlinie 47 ausgehenden Teilstrahlenbündels bei Ablenkung in der durch die Strahleneinfallsrichtung und Brennlinie 47 aufgespannten Ebene gross und bei Ablenkung in der dazu senkrechten Ebene klein ist. Die Verwendung einer Quadrupoloptik, bei der die zu einer ersten Dingebene astigmatisch konjugierten zwei Bildebenen zu einer zweiten, optisch verschiedenen Dingebene auch wieder gemeinsam astigmatisch konjugiert sind, ermöglicht ein stigmatisch abbildendes, aus zwei derartigen Quadrupoloptiken zusammengesetztes System, mit dem die Brennlinie 47 stigmatisch auf das Target 53 abgebildet wird. Darüber hinaus existieren bei einem derartigen Aufbau der Quadrupoloptik Zwischenbildebenen der stigmatischen und astigmatischen Abbildung, in denen die Ablenkzentren von Ablenkvorrichtungen liegen können, die zum Justieren des Strahlenbündels 40 benötigt werden.

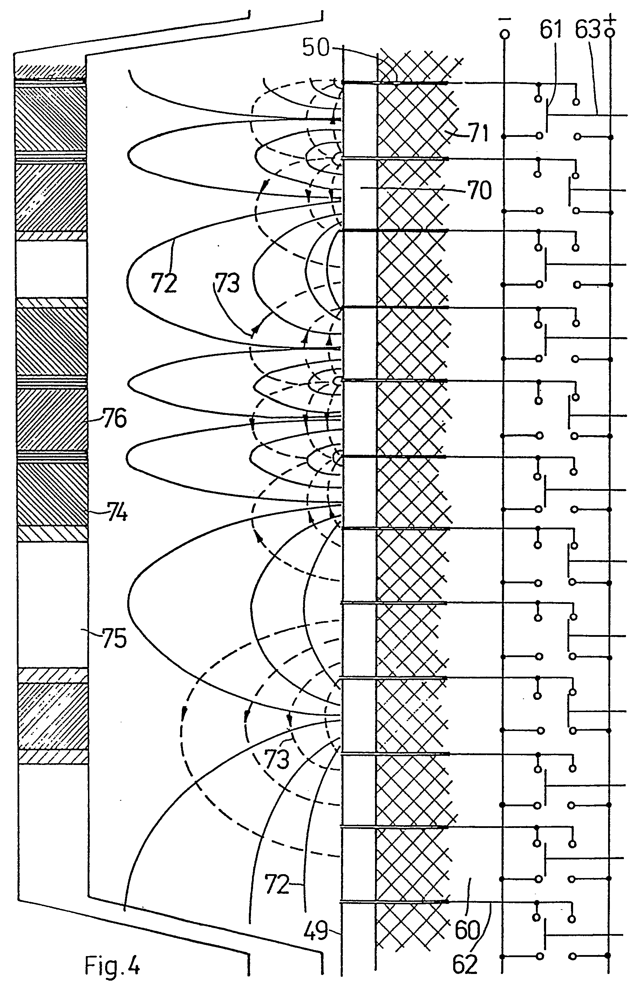

In Fig. 4 ist ein Stück der Elektrodenzeile 49 (Fig. 3) in Draufsicht stark vergrössert dargestellt. Die stegförmigen Elektroden 50 sind über die Zuleitungen 62 mit den elektronischen Schaltern 61 verbunden (Fig. 3). Zwischen den Elektroden 50 sind an der Stirnseite der Elektrodenzeile 49 ein weniger gut leitendes Substrat 70 eines Halbleiters (Silizium) und darunter ein isolierendes Substrat 71 ($SiO_2$) vorgesehen, in dem auch die Zuleitungen 62 verlegt sind. Alle genannten elektronischen Bauelemente befinden sich auf der Halbleiterscheibe 60 und sind durch nicht dargestellte metallische Blenden abgedeckt. Die Dicke der Halbleiterscheibe 60 beträgt 100 bis 200 µm, die Dicke der Elektroden wenige 0,1 µm und der Abstand der Elektroden entlang der Elektrodenzeile wenige Mikrometer. Das an die Elektroden angelegte Binärpotential ist durch Pole + und − gekennzeichnet. Haben zwei benachbarte Elektroden unterschiedliches Potential, so bildet sich zwischen ihnen ein elektrisches Feld aus, dessen Äquipotentiallinien 72 und dessen Feldstärkelinien 73 gestrichelt sind. Die Richtungen dieser Linien sind durch Pfeile gekennzeichnet. Der Gradient des auf der Elektrodenzeile 49 erzeugten Feldes ist in den Bereichen 51 zwischen den Elektroden 50 mit Potentialunterschied parallel zur Elektrodenzeile 49 und in den Bereichen ohne Potentialunterschied senkrecht zur Elektrodenzeile 49 gerichtet. Diese Richtung des Gradienten (Feldstärke) ist unabhängig vom angelegten Binärpotential (Strukturmuster) in den übrigen Bereichen. Die Gradientstärke in den Bereichen ohne Potentialunterschied wird um so schwächer, je grösser der Abstand zum nächstgelegenen Bereich mit Potentialunterschied ist. Auf das geformte Strahlenbündel 40 (Fig. 3) wirkt in der Ebene der Elektrodenzeile 49 nur die parallel zu dieser Zeile verlaufende Feldstärkekomponente steuernd ein. Bei einer in der Nähe der Elektrodenzeile 49 erzeugten, der Übersichtlichkeit wegen nicht dargestellten Brennlinie (47 in Fig. 3) kommen die Feldbereiche zur Wirkung, in denen die Feldlinien einen gekrümmten Verlauf nehmen. Die stromsteuernde Feldstärkekomponente wird in Bereichen mit Potentialunterschied geschwächt und greift auf benachbarte Bereiche ohne Potentialunterschiede über. Die Steilheit des Kontrastes an der Trennstelle zweier unterschiedlich gesteuerter Bildintervalle wird abgeflacht. In dem aus Gründen der Übersichtlichkeit versetzt dargestellten Abschnitt 74 der Brennlinie ist das dem Feldlinienbild entsprechende Kontrastverhalten dargestellt. Es sind deutlich die hell- bzw. dunkelgesteuerten Abschnitte 75 bzw. 76 zu erkennen. Der Signalcharakter bleibt in jedem Fall deutlich erhalten.

Es versteht sich von selbst, dass zwei Elektrodenzeilen zur Brennlinie 47 parallel und einander gegenüberliegend angeordnet sein können, von denen die eine steuert, wenn die andere geladen wird.

**Patentansprüche**

1. Verfahren zur Korpuskularbestrahlung, insbesondere Elektronenbestrahlung, eines Targets zur Erzeugung eines Belichtungsmusters, bei dem ein Korpuskularstrahlenbündel im Querschnitt begrenzt, in seiner Intensität strukturiert und auf das Target übertragen wird und bei dem elektromagnetische Felder zum Fokussieren und Ablenken des Korpuskularstrahlenbündels erzeugt werden, dadurch gekennzeichnet, dass eine Vielzahl zusätzliche elektromagnetische Felder erzeugt und gesteuert werden, die die Intensität des Korpuskularstrahlenbündels innerhalb seines Querschnittes strukturieren.

2. Vorrichtung zur Durchführung des Verfahrens gemäss Anspruch 1, bei der eine Strahlquelle (1) über ein Umlenkprisma (6) und ein Objektiv (7 bis 10) in die dingseitige Brennebene des Verzögerungsfeldes eines Elektronenspiegels (13) und nach Reflexion am Elektronenspiegel (13) über das Umlenkprisma (6) in die Eintrittspupille eines Objektivs (16) abgebildet wird, bei dem ferner strahlbegrenzende Mittel (12) auf die Oberfläche des Elektronenspiegels (13) und über das Umlenkprisma (6) durch das Objektiv (16) auf ein Target (20) abgebildet werden, dadurch gekennzeichnet, dass die Oberfläche des Elektronenspiegels (13) matrixartig ausgebildet ist und die einzelnen Matrixelemente (14) voneinander elektrisch isoliert und mit einer Spannungsquelle (29) über je einen zugeordneten elektronischen Schalter (25) verbindbar sind, und dass die Schalter durch ein Speichersystem (34) selektiv steuerbar sind.

3. Vorrichtung nach Anspruch 2, dadurch gekennzeichnet, dass zumindest in der Nähe der bildseitigen Brennebene des Beschleunigungsfeldes des Elektronenspiegels (13) eine Blende (12) angeordnet ist.

4. Vorrichtung zur Durchführung des Verfahrens gemäss Anspruch 1, bei der eine Strahlquelle (41) durch eine Quadrupoloptik (46) astigmatisch in eine erste (47) und zweite (48) reelle Brennlinie abgebildet wird und bei der die erste Brennlinie (47) über eine Linsenanordnung (52) stigmatisch auf ein Target (53) abgebildet wird, dadurch gekennzeichnet, dass die zweite Brennlinie (48) auf die Öffnung einer Spaltblende (58) eingestellt ist und dass parallel und unmittelbar angrenzend an die erste Brennlinie (47) mindestens eine Elektrodenzeile (49) angeordnet ist, deren Elektroden (50) voneinander elektrisch isoliert (51) und mit einer Spannungsquelle (66) über elektronische Schalter (61) verbindbar sind, die von einem Speichersystem gesteuert werden.

5. Vorrichtung nach Anspruch 4, dadurch gekennzeichnet, dass die Elektroden (50) entlang der Kante einer Halbleiterscheibe (60) angeordnet sind und die Kante überragen.

6. Vorrichtung nach Anspruch 5, dadurch gekennzeichnet, dass die Elektroden (50) als schmale Stege, verglichen mit ihren isolierenden Abständen (51), ausgebildet sind.

7. Vorrichtung nach einem der Ansprüche 4 bis 6, dadurch gekennzeichnet, dass die Linsenanordnung (52) eine weitere Quadrupoloptik ist.

## Claims

1. Process for the corpuscular irradiation, particularly electron irradiation, of a target for producing an exposure pattern, wherein a beam of corpuscular radiation is limited in cross-section, structured in its intensity, and transmitted to the target, and wherein electromagnetic fields are generated for focusing and deflecting the beam of corpuscular radiation, characterized in that a plurality of additional electromagnetic fields which structure the intensity of the beam of corpuscular radiation within its cross-section are generated and controlled.

2. Device for carrying out the process according to Claim 1, wherein an image of a beam source (1) is projected *via* a deviating prism (6) and an objective (7 to 10) into the object-side focal plane of the retardation field of an electron mirror (13) and, after reflection on the electron mirror (13), *via* the deviating prism (6) into the entrance pupil of an objective (16), further wherein an image of beam-limiting means (12) is projected onto the surface of the electron mirror (13) and *via* the deviating prism (6) through the objective (16) onto a target (20), characterized in that the surface of the electron mirror (13) is formed matrix-like, and the individual matrix elements (14) are electrically insulated from one another and connectible to a voltage source (29) *via* an associated electronic switch (25) each, and that the switches are selectively controllable by a memory system (34).

3. Device according to Claim 2, characterized in that a shutter (12) is disposed at least close to the image-side focal plane of the acceleration field of the electron mirror (13).

4. Device for carrying out the process according to Claim 1, wherein an image of a beam source (21) is astigmatically projected through a quadrupole optical system (46) into a first (47) and second (48) real focal line, and wherein an image of the first focal line (47) is stigmatically projected *via* a lens arrangement (52) onto a target (53), characterized in that the second focal line (48) is adjusted on the aperture of a slit diaphragm, and that at least one row of electrodes (49) is disposed immediately adjacent to the first focal line (47), the electrodes (50) of which row are electrically insulated (51) from one another and connectible to a voltage source (66) *via* electronic switches (61) controlled by a memory system.

5. Device according to Claim 4, characterized in that the electrodes (50) are disposed along the edge of a semiconductor plate (60) and project beyond the edge.

6. Device according to Claim 5, characterized in that the electrodes (50) are formed as narrow crosspieces, compared with their insulating separations.

7. Device according to one of the Claims 4 to 6, characterized in that the lens arrangement (52) is a further quadrupole optical system.

## Revendications

1. Procédé pour l'irradiation corpusculaire, notamment l'irradiation électronique d'une cible, en vue de l'obtention d'un échantillon d'irradiation, procédé dans lequel un faisceau de rayonnement corpusculaire de section limitée est structuré en intensité et transféré sur la cible, et des champs électromagnétiques sont créés pour focaliser et dévier ledit faisceau, caractérisé en ce qu'une pluralité de champs électromagnétiques auxiliaires sont créés et commandés qui structurent l'intensité du faisceau dans sa section.

2. Dispositif pour la mise en œuvre du procédé selon la revendication 1, dans lequel une source de rayonnement (1) est reproduite dans le plan focal, situé du côté de l'objet, d'un miroir électronique (13) à travers un prisme de déviation (6) et un objectif (7 à 10) et, après réflexion sur le miroir électronique (13), dans la lentille d'entrée d'un objectif (16) par le prisme de déviation (6), et dans lequel des moyens (12) de limitation du rayonnement sont reproduits sur la surface du miroir électronique (13) ainsi que par le prisme de déviation (6) et à travers l'objectif (16) sur une cible (20), caractérisé en ce que la surface du miroir électronique (13) est conformée en matrice, en ce que les éléments (14) de la matrice sont isolés électriquement les uns des autres et connectés chacun à travers un interrupteur électronique particulier (25) à une source de tension (29), les interrupteurs pouvant être commandés sélectivement par un système à mémoire.

3. Dispositif selon la revendication 2, caractérisé en ce qu'au moins au voisinage du plan focal côté objet du champ d'accélération du miroir électronique (13) est disposé un diaphragme (12).

4. Dispositif pour la mise en œuvre du procédé selon la revendication 1, comprenant la reproduction d'une source de rayonnement (41) par un système optique quadripolaire (46) de manière astigmatique dans une première (47) et une seconde (48) ligne focale, la première ligne focale (47) étant reproduite par un agencement de lentilles (52) d'une manière stigmatique sur une cible (53), caractérisé en ce que la seconde ligne focale (48) est ajustée sur l'ouverture d'un diaphragme à fente (58) et en ce qu'au moins une rangée d'électrodes (49) est disposée parallèlement à et à proximité immédiate de la première ligne focale (47), les électrodes (50) de ladite rangée étant électriquement isolées les unes des autres (51) et connectées à une source de tension (66) par des interrupteurs électroniques (61) qui sont commandés par un système à mémoire.

5. Dispositif selon la revendication 4, caractérisé en ce que les électrodes (50) sont disposées le long du bord d'un disque semi-conducteur (60) et dépassent le bord de ce disque.

6. Dispositif selon la revendication 5, caractérisé en ce que les électrodes (50) forment des bandes étroites par rapport aux espaces (51) qui les isolent.

7. Dispositif selon l'une des revendications 4 à ·6, caractérisé en ce que l'agencement de lentilles (52) forme un système optique quadripolaire supplémentaire.

0 028 585

Fig.1

Fig. 2

0 028 585

Fig. 3

13

Fig.4